# EUROPEAN PATENT SPECIFICATION

(11) **EP 3 988 945 B1**
(45) Date of publication and mention of the grant of the patent: **15.05.2024**
(21) Application number: 21195640.4
(22) Date of filing: 08.09.2021
(51) Int. Cl.: G01R 15/18, G01R 31/12, H02S 50/10, H02S 50/00

(54) **METHOD AND DEVICE FOR DETECTING DIRECT CURRENT ARC, AND STRING INVERTER**
VERFAHREN UND VORRICHTUNG ZUR DETEKTION EINES GLEICHSTROMLICHTBOGENS UND STRINGWECHSELRICHTER
PROCÉDÉ ET DISPOSITIF DE DÉTECTION D'ARC DE COURANT CONTINU ET ONDULEUR CENTRAL

(30) Priority: 21.10.2020 CN 202011131658
(43) Date of publication of application: 27.04.2022
(73) Proprietor: Sungrow Power Supply Co., Ltd., Hefei, Anhui 230088 (CN)
(72) Inventor: Hou, Peng, Hefei, Anhui 230088 (CN); Zhou, Yinyin, Hefei, Anhui 230088 (CN); Zhu, Wanping, Hefei, Anhui 230088 (CN)
(74) Representative: Zacco Norway AS

(56) References cited:
- EP-A1- 3 349 317
- JP-A- 2019 045 422
- US-A1- 2012 319 489
- Martin Murnane: "Arc Detection Analysis for Solar Applications", , 31 December 2017 (2017-12-31), pages 1-4, XP055721443, Retrieved from the Internet: URL:https://www.analog.com/media/en/techni cal-documentation/tech-articles/arc-detect ion-analysis-for-solar-applications.pdf [retrieved on 2020-08-11]

## Description

### FIELD

The present disclosure relates to the technical field of power electronics, and in particular to a method and a device for detecting a direct current arc, and a string inverter.

### BACKGROUND

With large-scale application of photovoltaic power generation technology, blazes caused by an electric arc at a direct current side is increasing. A photovoltaic module is connected to another photovoltaic module via terminal blocks. Further, a photovoltaic module is connected to an inverter via terminal blocks. These terminal blocks may be loose and ageing, and contact between terminal blocks may be poor, resulting in a direct current arc. Based on characteristics of a photovoltaic power generation system, electricity flows through the direct current side whenever sunlight shines on the photovoltaic power generation system. Therefore, it is required to provide a device for detecting a direct current arc in the photovoltaic power generation system. In addition, the device for detecting a direct current is required to operate safely and reliably during power generation.

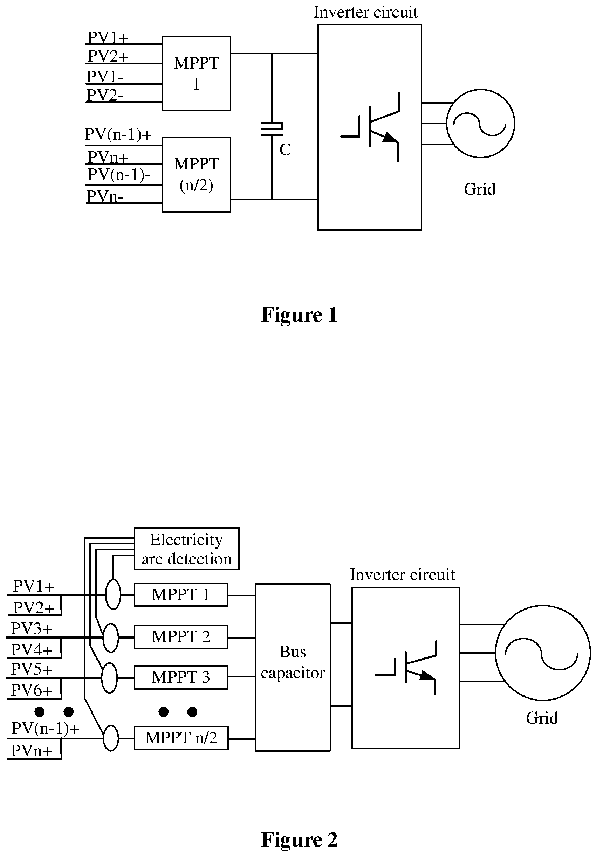

As shown in Figure 1, in a string inverter, two photovoltaic strings are connected to a maximum power point tracking (MPPT) circuit. For example, in Figure 1, photovoltaic strings PV1 and PV2 are connected to a MPPT circuit MPPT1, and two photovoltaic strings PV(n-1) and PV(n) are connected to a MPPT circuit MPPT(n/2). An output end of the MPPT circuit is connected to a bus capacitor C. The bus capacitor C is connected to a grid via an inverter circuit.

As shown in Figure 2, in the existing solutions for detecting a direct current arc, on the direct current side, a detection magnetic ring of a straight-through current transformer is arranged between an input end of the MPPT circuit and an end at which outputs of all PV modules connected to the MPPT circuit are aggregated, to detecting a direct current arc. However, the number of photovoltaic strings varies from one MPPT circuit to another MPPT circuit. Further, all PV modules connected to the same MPPT circuit may vary in model. Therefore, harmonic characteristics of one MPPT circuit may differ from harmonic characteristics of another MPPT circuit, leading to detection results varying from one MPPT circuit to another MPPT circuit. The various detection results being analyzed in the same manner may result in low detection accuracy and low safety.

US 2012/0319489 A1 discloses a PV string-level equalizer, which may also be used in arc-fault detection. When an arc fault is detected, the inverter connected to the DC bus is shut down until the fault is isolated and repaired. The arc-fault detection at the PV string level may provide better sensitivity (due to better signal to noise ratios SNRs), better PV string-level detection isolation, faster onset detection, and automatic/isolated disabling of the PV string(s) upon detection.

EP 3 349 317 A1 discloses methods for arc detection in a system including one or more photovoltaic generators, one or more photovoltaic power devices and a system power device and/or a load connectible to the photovoltaic generators and/or the photovoltaic power devices.

JP 2019 045422 A discloses an arc detector capable of locating a place of generation of an arc without stopping power generation by a solar cell module even in solar power generation systems in various configurations.

Martin Murnane: "arc detection analysis for solar applications" 31 December 2017, pages 1-4, discloses an arc detection analysis method. The current in the load and the current to ground is monitored. The current in the load is passed through a filter, leaving only the characteristic frequency range of the arc. Signal conditioning is then performed and a logic mechanism shuts down the arcing source, the PV module or PV inverter.

### SUMMARY

In view of this, a method and a device for detecting a direct current arc, and a string inverter are provided according to the present disclosure, to improve accuracy in electric arc detection on a direct current side of a string inverter and improve safety of the string inverter.

A method for detecting a direct current arc is provided according to a first aspect of the present disclosure. The method includes: for each of N photovoltaic strings connected to an input end of an MPPT circuit in a string inverter, acquiring a current detection result of the photovoltaic string; removing a background noise signal from the N current detection results corresponding to the MPPT circuit; and performing data processing and harmonic characteristics analysis on a result corresponding to the MPPT circuit including no background noise signal, to obtain a direct current arc detection result for the N photovoltaic strings corresponding to the MPPT circuit.

In an embodiment, the for each of N photovoltaic strings connected to an input end of an MPPT circuit in a string inverter, acquiring a current detection result of the photovoltaic string includes: inputting the N current detection results corresponding to the MPPT circuit respectively to an input terminal of N multi-input switches; and controlling the N multi-input switches to operate to output the N current detection results corresponding to the MPPT circuit at the same time instant.

In an embodiment, the removing a background noise signal from the N current detection results corresponding to the MPPT circuit includes: calculating a difference between two of the N current detection results corresponding to the MPPT circuit, as the result corresponding to the MPPT circuit including no background noise signal.

In an embodiment, the data processing includes filtering-amplification and analog-to-digital conversion.

In an embodiment, N is equal to 2.

A device for detecting a direct current arc is provided according to a second aspect of the present disclosure. The device includes a selection module, a processing module and M*N current transformers. M represents the number of MPPT circuits in a string inverter that correspond to the device for detecting a direct current arc. N represents the number of photovoltaic strings connected to each of the M MPPT circuits. M is a positive integer, and N is an integer greater than 1. M*N photovoltaic strings are in one-to-one correspondence with the M*N current transformers. For each of the M*N photovoltaic strings, an output cable of the photovoltaic string passes through a magnetic ring of a current transformer corresponding to the photovoltaic string. Input ends of the selection module are connected to an output end of the M*N current transformers in one-to-one correspondence. The selection module is configured to acquire, for each of the M MPPT circuits in the string inverter, current detection results of N photovoltaic strings connected to an input end of the MPPT circuit. The processing module is configured to, for each of the M MPPT circuits, remove a background noise signal from N current detection results corresponding to the MPPT circuit, and perform data processing and harmonic characteristics analysis on a result corresponding to the MPPT circuit including no background noise signal, to obtain a direct current arc detection result for the N photovoltaic strings corresponding to the MPPT circuit.

In an embodiment, the selection module includes N multi-input switches. For each of the M MPPT circuits: an output end of the N current transformers corresponding to the MPPT circuit is connected to an input terminal of the N multi-input switches, where the N current transformers are in one-to-one correspondence to the N multi-input switches; and the N multi-input switches are configured to be controlled to operate to output N current detection results corresponding to the MPPT circuit at the same time instant.

In an embodiment, the processing module includes a processor and a data processing unit. For each of the N multi-input switches, an output end of the multi-input switch is connected to the processor via the data processing unit. For each of the M MPPT circuits: the data processing unit is configured to remove a background noise signal from N current detection results corresponding to the MPPT circuit; and perform data processing on the result corresponding to the MPPT circuit including no background noise signal; and the processor is configured to control the N multi-input switches to operate to output N current detection results corresponding to the MPPT circuit at the same time instant; and perform harmonic characteristic analysis on data outputted by the data processing unit, to obtain a direct current arc detection result for N photovoltaic strings corresponding to the MPPT circuit.

In an embodiment, N current transformers corresponding to a same MPPT circuit are all arranged in a same direction.

In an embodiment, the data processing unit includes a signal difference module and a filter amplifier circuit. For each of the M MPPT circuits: the signal difference module is configured to calculate a difference between two of N current detection results corresponding to the MPPT circuit, to remove a background noise signal from the N current detection results outputted by N current transformers corresponding to the MPPT circuit; and the filter amplifier circuit is configured to perform data processing on the result corresponding to the MPPT circuit including no background noise signal.

In an embodiment, the signal difference module is implemented by a hardware circuit or a software module.

In an embodiment, at least one of N current transformers corresponding to a same MPPT circuit is arranged opposite to other current transformers of the N current transformers corresponding to the MPPT circuit, to remove a background noise signal.

In an embodiment, N is equal to 2.

In an embodiment, the device for detecting a direct current arc further includes N self-check circuits. The N multi-input switches are in one-to-one correspondence with the N self-check circuits. For each of the N self-check circuits, the self-check circuit is configured to detect whether a multi-input switch corresponding to the self-check circuit has a fault.

A string inverter is provided according to a third aspect of the present disclosure. The string inverter includes an inverter circuit, at least one MPPT circuit and at least one the device for detecting a direct current arc. For each of the at least one MPPT circuit: an input end of the MPPT circuit is connected to a photovoltaic string; the device for detecting a direct current arc is configured to detect a direct current arc for the photovoltaic string connected to the MPPT circuit; and an output end of the MPPT circuit is connected to a direct current side of the inverter circuit. An alternating current end of the inverter circuit is connected to a power grid.

It can be seen from the above technical solutions that, the method for detecting a direct current arc according to the present disclosure includes: for each of N photovoltaic strings connected to an input end of an MPPT circuit in a string inverter, acquiring a current detection result of the photovoltaic string; removing a background noise signal from the N current detection results corresponding to the MPPT circuit based on a principle that characteristics of photovoltaic strings connected to the same MPPT circuit are relatively consistent, so that the result including no background noise signal includes only an electricity arc signal; and performing data processing and harmonic characteristics analysis on the result corresponding to the MPPT circuit including no background noise signal, to obtain a direct current arc detection result for the N photovoltaic strings corresponding to the MPPT circuit. Therefore, even if photovoltaic strings vary from one MPPT circuit to another MPPT circuit and even photovoltaic modules connected to the same MPPT circuit vary in model, a difference in detection resulted from the fact is eliminated by performing the above steps, and subsequent analysis is performed on detection results without the difference. Therefore, accuracy in detection of the direct current arc and safety of the string inverter are improved compared with the conventional technology.

### BRIEF DESCRIPTION OF THE DRAWINGS

Drawings to be used in description of embodiments of the present disclosure or the conventional technology are briefly described below, for clear illustration of technical solutions in the embodiments or in the conventional technology. Apparently, the drawings in the following description show only some embodiments of the present disclosure, and other drawings may be obtained by those skilled in the art from the disclosed drawings without any creative work.
Figure 1 is a schematic diagram of a string inverter according to the conventional technology;
Figure 2 is a schematic diagram showing a solution for detecting a direct current arc according to the conventional technology;
Figure 3 is a flowchart of a method for detecting a direct current arc according to an embodiment of the present disclosure;
Figure 4 is a schematic diagram showing a harmonic analysis result corresponding to a direct current cable before an electric arc according to an embodiment of the present disclosure;
Figure 5 is a schematic diagram showing a harmonic analysis result corresponding to the direct current cable after the electric arc according to an embodiment of the present disclosure;
Figure 6 is a schematic diagram showing a difference between the harmonic analysis result on the direct current cable before the electric arc and the harmonic analysis result on the direct current cable after the electric arc according to an embodiment of the present disclosure;
Figure 7 is a flowchart of a method for detecting a direct current arc according to another embodiment of the present disclosure;
Figure 8 is a flowchart of a device for detecting a direct current arc according to an embodiment of the present disclosure; and
Figure 9 is a schematic diagram showing a string inverter according to an embodiment of the present disclosure.

### DETAILED DESCRIPTION OF EMBODIMENTS

Technical solutions in the embodiments of the present disclosure are described clearly and completely in conjunction with the drawings in the embodiments of the present disclosure hereinafter, so that objects, technical solutions and advantages of the embodiments of the present disclosure are clearer. It is apparent that the described embodiments are only some rather than all embodiments of the present disclosure. All other embodiments obtained by those skilled in the art based on the embodiments of the present disclosure without any creative work fall within the protection scope of the present disclosure.

In this specification, terms of "include", "comprise" or any other variants are intended to be non-exclusive. Therefore, a process, method, article or device including a series of elements includes not only these elements but also other elements that are not enumerated, or also includes elements inherent for the process, method, article or device. Unless expressively limited otherwise, the statement "comprising (including) one... " does not exclude a case that the process, method, article or device further includes other similar elements.

A method for detecting a direct current arc is provided according to an embodiment of the present disclosure, so as to solve the problem of low detection accuracy and low safety resulted from various detection results being analyzed in the same manner based on a fact that harmonic characteristics of one MPPT circuit differ from harmonic characteristics of another MPPT circuit thereby leading to detection results varying from one MPPT circuit to another MPPT circuit.

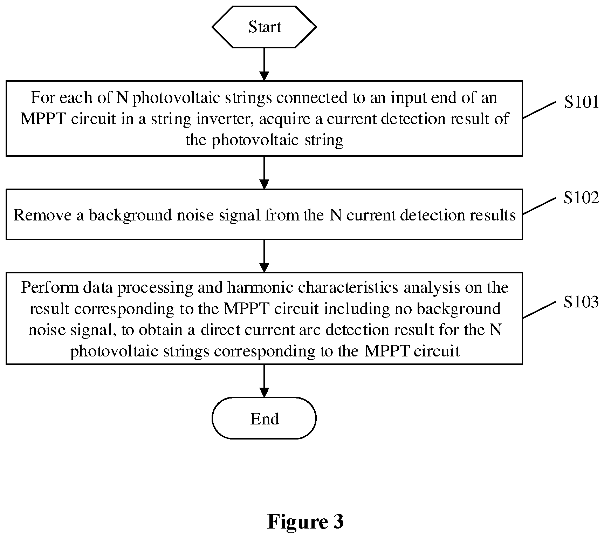

Referring to Figure 3, the method for detecting a direct current arc includes the following steps S101 to S103.

In step S101, for each of N photovoltaic strings connected to an input end of an MPPT circuit in a string inverter, a current detection result of the photovoltaic string is acquired.

It should be noted that the string inverter includes at least one MPPT circuit. For each of the at least one MPPT circuit, an input end of the MPPT circuit is connected to N photovoltaic strings.

N is an integer greater than 1. N may be equal to 2. Alternatively, N may be equal to other numbers, which are not listed herein, and are within the protection scope of the present disclosure.

In practical applications, the N photovoltaic strings each are provided with a current transformer. That is, for each of the N photovoltaic strings, an output cable of the photovoltaic string passes through a magnetic ring of a current transformer corresponding to the photovoltaic string, so that a current detection result of the photovoltaic string is acquired. The N photovoltaic strings are in one-to-one correspondence with N current transformers.

In step S 102, a background noise signal is removed from the N current detection results corresponding to the MPPT circuit.

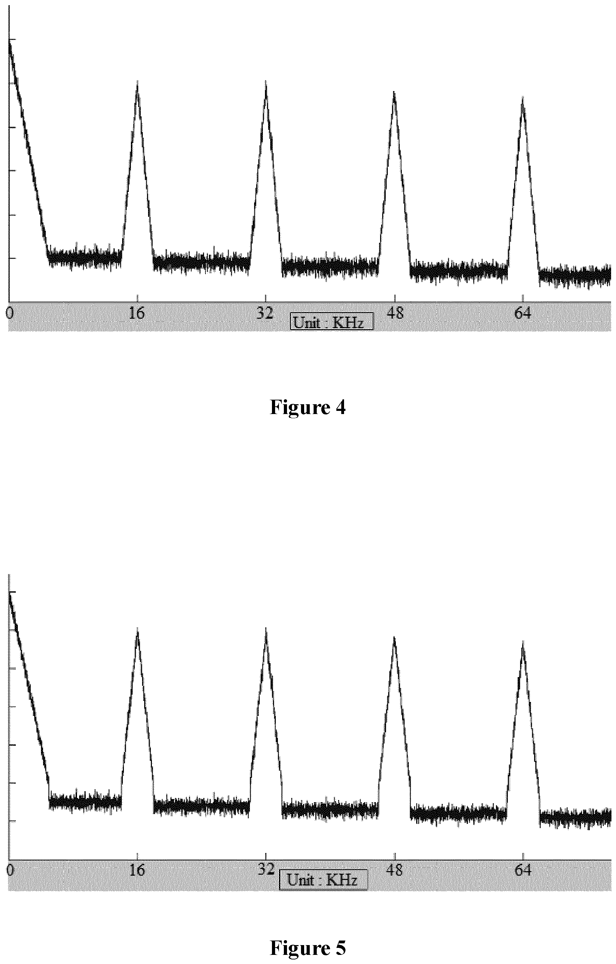

Figure 4 is a schematic diagram showing a harmonic analysis result corresponding to a direct current cable before an electric arc. Figure 5 is a schematic diagram showing a harmonic analysis result corresponding to the direct current cable after the electric arc. It can be seen form comparison between Figure 4 and Figure 5 that, contours of certain parts of the harmonic analysis result before the electric arc are the same as contours of the certain parts of the harmonic analysis result after the electric arc. That is, the certain parts of the harmonic analysis result serve as an analysis result of the background noise signal. After the electric arc formed on the direct current cable, a high harmonic is added to the background noise signal as shown in Figure 4.

Characteristics of one photovoltaic string may differ from or may be identical to characteristics of another photovoltaic string, and harmonic characteristics of one MPPT circuit may differ from harmonic characteristics of another MPPT circuit. However, due to MPPT characteristics of the string inverter, characteristics of photovoltaic strings connected to the same MPPT circuit are approximately identical to each other. Further, a probability that two photovoltaic strings among the N photovoltaic strings connected to the same MPPT circuit simultaneously have an electric arc is extremely low. Therefore, the current detection result includes only an electric arc signal after the background noise signal is removed, so that the analysis result of the background noise signal is removed from the harmonic analysis result. That is, in step S 102, differential harmonic characteristics of a branch having an electric arc is obtained, and a difference in harmonic characteristics between MPPT circuits is eliminated, thereby avoiding influence on a subsequent direct current arc detection result resulted from a large difference in characteristics between photovoltaic strings.

In practical applications, step S 102 includes a step of: for any two of the N current detection results corresponding to MPPT circuit, calculating a difference between the two current detection results, as a result corresponding to the MPPT circuit including no background noise signal. Specifically, for any two of the N current detection results corresponding to the MPPT circuit, the difference between the two current detection results is acquired as result corresponding to the MPPT circuit including no background noise signal. Alternatively, a difference among all the N current detection results corresponding to the same MPPT circuit is calculated, as a result corresponding to the MPPT circuit including no background noise signal. Details in step S 102 are not limited herein and depend on actual applications, and are all within the protection scope of the present disclosure.

In step S103, data processing and harmonic characteristics analysis are performed on the result corresponding to the MPPT circuit including no background noise signal, to obtain a direct current arc detection result for the N photovoltaic strings corresponding to the MPPT circuit.

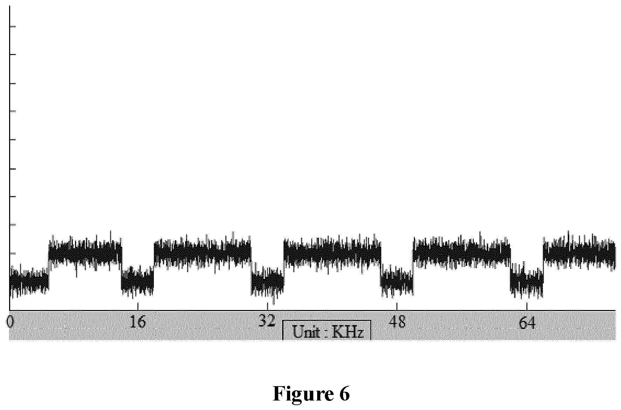

Figure 6 is a schematic diagram showing a difference between the harmonic analysis result on the direct current cable before the electric arc and the harmonic analysis result on the direct current cable after the electric arc. That is, the certain parts of the harmonic analysis result shown in Figure 4 that has the same contours as the harmonic analysis result shown in Figure 5 are removed to obtain the result including no background noise signal, and data processing and harmonic characteristics analysis are performed on the result including no background noise signal to obtain the difference shown in Figure 6.

Specifically, the data processing is performed on the result including no background noise signal, so that the result including no background noise signal is converted into data for harmonic characteristics analysis. The harmonic characteristics analysis is performed on the result obtained from data processing, to obtain a result of harmonic characteristics analysis, as shown in Figure 6.

In practical applications, the data processing includes: filtering and amplifying processing and analog-to-digital conversion. The filtering and amplifying processing includes filtering out a signal with a certain band frequency and amplifying an input analog signal. The analog-to-digital conversion includes converting the input analog signal into a digital signal.

In this embodiment, although there is the fact that the number of photovoltaic strings vary from one MPPT circuit to another MPPT circuit and even photovoltaic modules connected to the same MPPT circuit vary in model, a difference in detection resulted from the fact is eliminated by performing the above steps, and subsequent analysis is performed on detection results without the difference. Therefore, accuracy in detection of the direct current arc and safety of the string inverter are improved compared with the conventional technology.

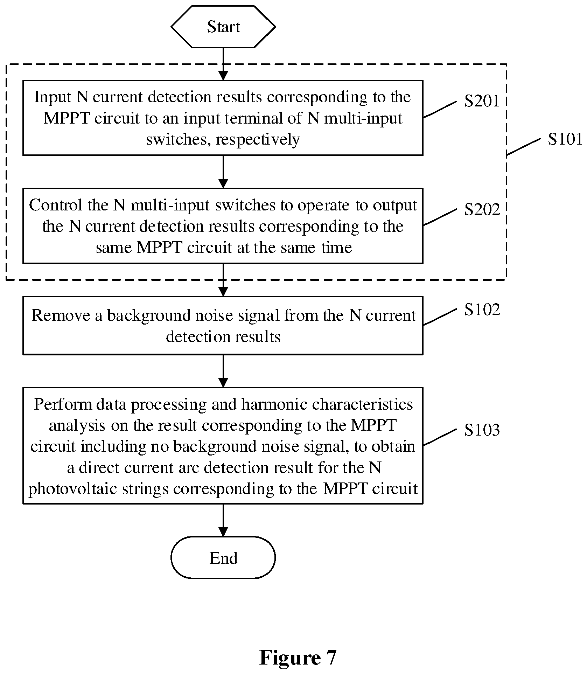

In practical applications, as shown in Figure 7, step S 101 includes the following steps S201 to S202.

In step S201, N current detection results corresponding to the MPPT circuit are respectively inputted to an input terminal of N multi-input switches.

Specifically, the N current detection results corresponding to the MPPT circuit are in one-to-one correspondence with the N multi-input switches. In case of M MPPT circuits, each of the M MPPT circuits corresponds to N current detection results. Therefore, each of the N multi-input switches receives M current detection results respectively from the M MPPT circuits.

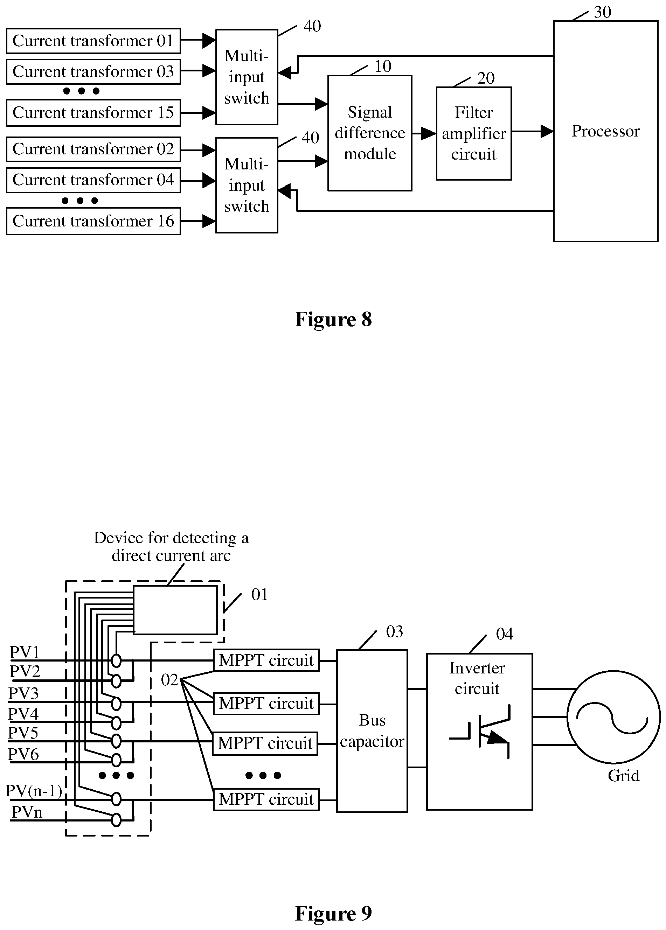

In Figure 8, a case of N=2 is taken as an example for illustration. There are 8 MPPT circuits, and each of the 8 MPPT circuits corresponds to 2 current detection results. For example, current detection results corresponding to a first MPPT circuit includes a current detection result detected by a current transformer 01 and a current detection result detected by a current transformer 02, and current detection results corresponding to a second MPPT circuit includes a current detection result detected by a current transformer 03 and a current detection result detected by a current transformer 04, and so on. Current detection results corresponding to an eighth MPPT circuit includes current detection results detected by current transformers 15 and 16. Current transformers with an odd serial number, namely, the current transformer 01, the current transformer 03 to the current transformer 15 are connected to input terminals of a first multi-input switch 40. Current transformers with an even serial number, namely, the current transformer 02, the current transformer 04 to the current transformer 16 are connected to input terminals of a second multi-input switch 40. That is, for each of the 8 MPPT circuits, one current detection result of the MPPT circuit is inputted to one input terminal of the first multi-input switch 40, and the other current detection result of the MPPT circuit is inputted to one input terminal of the other multi-input switch 40. In this case, each of the first and second multi-input switches 40 is an 8-to-1 switch. Alternatively, each of the first and second multi-input switches 40 is a multi-input switch with a floating input terminal, that is, a multi-input switch including more than 8 input terminals.

In step S202, the N multi-input switches are controlled to operate to output the N current detection results corresponding to the same MPPT circuit at the same time instant.

That is, each of the N multi-input switch receives M current detection results and outputs one current detection result. At a certain time instant, current detection results outputted by the N multi-input switches correspond to the same MPPT circuit.

It should be noted that, according to the above description, arc detection for the M MPPT circuits is performed separately. In another embodiment, arc detection for the M MPPT circuits is performed simultaneously. In the case that the arc detection for the M MPPT circuits is performed simultaneously, multiple processing modules are required for subsequent processing, resulting in large cost. Alternatively, step S101 is performed in a form of software processing, depending on actual applications. All solutions for implementing step S101 are within the protection scope of the present disclosure.

A device for detecting a direct current arc is provided according to an embodiment of the present disclosure. As shown in Figure 8, the device includes a selection module (for example, 40 shown in Figure 8), a processing module (for example, 10, 20, and 30 shown in Figure 8) and M*N current transformers (a current transformer 01, a current transformer 02, ..., a current transformer 15 and a current transformer 16 shown in Figure 8). M represents the number of MPPT circuits in a string inverter that correspond to the device for detecting a direct current arc. N represents the number of photovoltaic strings connected to each of the M MPPT circuits.

M is a positive integer. N is an integer greater than 1. N may be equal to 2. Alternatively, N may be equal to other numbers, which are not limited herein, and are within the protection scope of the present disclosure. A value of M is not limited herein, and depends on the actual applications. Any value of M is within the protection scope of the present disclosure.

M*N photovoltaic strings are in one-to-one correspondence with the M*N current transformers. For each of the M*N photovoltaic strings, an output cable of the photovoltaic string passes through a magnetic ring of a current transformer corresponding to the photovoltaic string. Specifically, as shown in Figure 8, an output cable of a photovoltaic string PV1 passes through a magnetic ring of a current transformer 01, an output cable of a photovoltaic string PV2 passes through a magnetic ring of a current transformer 02, and so on. An output cable of a photovoltaic string PV16 passes through a magnetic ring of a current transformer 16.

For each of the M*N current transformers, the current transformer is configured to detect a current of a photovoltaic string corresponding to the current transformer, and output a current detection result to the selection module.

Input ends of the selection module are connected to an output end of the M*N current transformers in one-to-one correspondence. The selection module is configured to acquire, for each of the M MPPT circuits in the string inverter, current detection results of the N photovoltaic strings connected to an input end of the MPPT circuit. That is, M*N current detection results of the M*N photovoltaic strings connected to input ends of the M MPPT circuits all are outputted to the selection module.

An output end of the selection module is connected to an input end of the processing module.

It should be noted that the selection module sequentially outputs all the M*N current detection results corresponding to the M MPPT circuits. That is, the selection module first outputs all the N current detection results corresponding to a MPPT circuit, and then outputs all the N current detection results corresponding to a next MPPT circuit. Alternatively, the selection module outputs all the M*N current detection results corresponding to the M MPPT circuits together. A manner in which the selection module outputs all the M*N current detection results is not limited herein, depending on actual applications. Any manner is within the protection scope of the present disclosure.

The processing module is configured to, for each of the M MPPT circuits, remove a background noise signal from the N current detection results corresponding to the MPPT circuit, and perform data processing and harmonic characteristics analysis on a result corresponding to the MPPT circuit including no background noise signal, to obtain a direct current arc detection result for the N photovoltaic strings corresponding to the MPPT circuit.

Processing process performed by the processing module varies with the manner in which the selection module outputs all the M*N current detection results. In the case that the selection module sequentially outputs all the M*N current detection results corresponding to the M MPPT circuits, the processing module first processes all the N current detection results corresponding to an MPPT circuit to obtain a direct current arc detection result of the N photovoltaic strings corresponding to the MPPT circuit. Then, the processing module processes all the N current detection results corresponding to a next MPPT circuit to obtain a direct current arc detection result of the N photovoltaic strings corresponding to the MPPT circuit. In the case that the selection module outputs all the M*N current detection results corresponding to the M MPPT circuits together, the processing modules processes all the M*N current detection results corresponding to the M MPPT circuits together, to obtain direct current arc detection results of the M*N photovoltaic strings corresponding to the M MPPT circuits.

As shown in Figure 8, the selection module includes N multi-input switches 40.

Output ends of the N current transformers corresponding to the same MPPT circuit are connected to an input terminal of the N multi-input switches 40.

Output terminals of the N multi-input switches 40 each serve as an output end of the selection module, and are connected to the input end of the processing module. The N multi-input switches 40 are controlled to operate to output the N current detection results corresponding to the same MPPT circuit at the same time instant.

Each of the N multi-input switches 40 selects one from more. For example, the M input terminals of the multi-input switch 40 are connected to the output ends of the M current transformers in one-to-one correspondence. That is, the multi-input switch 40 receives M current detection results, selects one current detection result from the M current detection results, and outputs the selected current detection result to the processing module. In addition, the multi-input switch 40 is controlled by the processing module. That is, the processing module controls the multi-input switch 40 to select any one current detection result.

In an example, N is equal to 2 and M is less than or equal to 8. For MPPT circuit, a photovoltaic string with an odd serial number and a photovoltaic string with an even serial number corresponding to the MPPT circuit are connected to two different 8-to-1 switchers, respectively. For example, output cables of photovoltaic strings PV1, PV3, PV5, PV7,..., PV15 are connected to a first 8-to-1 switch via respective current transformers. Output cables of photovoltaic strings PV2, PV4, PV6, PV8... PV16 are connected to a second 8-to-1 switch via respective current transformers. Therefore, one of the two 8-to-1 switches outputs a current direction result of one photovoltaic string with an odd serial number while the other of the two 8-to-1 switches outputs a current direction result of one photovoltaic string with an even serial number. For example, current direction results of the photovoltaic strings PV1 and PV2 are outputted to the data processing module.

As shown in Figure 8, the processing module includes a processor 30 and a data processing unit (including 10 and 20 as in Figure 8).

Output ends of the N multi-input switches 40 are connected to the processor 30 via the data processing unit. That is, the processor 30 receives current detection results outputted by the N multi-input switches 40.

The data processing unit is configured to, for each of the M MPPT circuits, remove a background noise signal from the N current detection results corresponding to the MPPT circuit, and perform data processing on the result corresponding to the MPPT circuit after the background noise signal is removed.

In practical applications, the data processing unit removes the background noise signal from the N current detection results corresponding to the same MPPT circuit as follows. The data processing unit calculates a difference between two of N current detection results corresponding to the MPPT circuit. The difference between the two current detection results serves as the current detection result corresponding to the MPPT circuit after the background noise signal is removed. Specifically, the data processing unit calculates a difference between any two of N current detection results corresponding to the MPPT circuit. The difference between the two current detection results serves as one current detection result corresponding to the MPPT circuit after the background noise signal is removed. Alternatively, the data processing unit calculates a difference of the N current detection results corresponding to the MPPT circuit. The difference of the N current detection results serves as the current detection result corresponding to the MPPT circuit after the background noise signal is removed.

Figure 8 shows an example in which N is equal to 2. Photovoltaic strings PV1 and PV2 are connected to a first MPPT circuit, photovoltaic strings PV3 and PV4 are connected to a second MPPT circuit, photovoltaic strings PV5 and PV6 are connected to a third MPPT circuit, and so on. Photovoltaic strings PV15 and PV16 are connected to an eighth MPPT circuit. A difference between a current detection result corresponding to the photovoltaic string PV1 and a current detection result corresponding to the photovoltaic string PV2 is calculated, so that a background noise corresponding to the photovoltaic strings PV1 and PV2 that are connected to the first MPPT circuit is removed. For the second to eight MPPT circuits, a background noise is removed as that for the first MPPT circuit.

The data processing unit performs data processing on the current detection result corresponding to the same MPPT circuit after the background noise signal is removed as follows. The data processing unit performs filtering and amplification. That is, a signal at a specific band frequency is filtered out, and an inputted analog signal is amplified. The data processing unit further performs analog-to-digital conversion. That is, the inputted analog signal is converted into a digital signal.

For the specific operation process of the data processing unit, refer to the above-mentioned embodiment for details, which are not repeated here.

The processor 30 is configured to control the N multi-input switches 40 to operate, so that the N multi-input switches 40 respectively output N current detection results corresponding to the same MPPT circuit at the same time instant. The processor 30 is further configured to perform harmonic characteristic analysis on data outputted by the data processing unit, to obtain a direct current arc detection result for the N photovoltaic strings corresponding to the MPPT circuit.

As shown in Figure 8, the processor 30 outputs a code 000 to the two multi-input switches 40, so that the first multi-input switch 40 outputs a current detection result corresponding to the current transformer 01, and the second multi-input switch 40 outputs a current detection result corresponding to current transformer 02. A photovoltaic string corresponding to the current transformer 01 and a photovoltaic string corresponding to the current transformer 02 are connected to the same MPPT circuit.

After receiving the result subjected to the data processing, the processor 30 performs harmonic characteristic analysis on the result subjected to the data processing, to obtain a harmonic characteristic analysis result.

A specific operation process of the processor 30 is not described in detail herein. Any processor 30 can control the N multi-input switches 40 to output the N current detection results corresponding to the same MPPT circuit at the same time instant and acquire direct current arc detection results of N photovoltaic strings corresponding to the MPPT circuit, is within the protection scope of the present disclosure.

The selection module and the processing module are not limited to those shown in Figure 8, which shows only a preferred example. For other optional examples, referred may be to the relevant description in the previous embodiment. Therefore, other optional examples of the selection module and the processing module are not enumerated herein.

In practical applications, N current transformers corresponding to the same MPPT circuit may be arranged as follows. In one embodiment, the N current transformers corresponding to the same MPPT circuit are all arranged in the same direction. In another embodiment, at least one of the N current transformers corresponding to the same MPPT circuit is arranged opposite to other current transformers of the N current transformers corresponding to the MPPT circuit, so as to remove the background noise signal.

In a case that N current transformers corresponding to a same MPPT circuit are all arranged in the same direction, the data processing unit includes a signal difference module 10 and a filter amplifier circuit 20 shown in Figure 8.

The signal difference module 10 is configured to calculate a difference between two of N current detection results corresponding to the MPPT circuit, so as to remove a background noise signal from current detection results outputted by N current transformers corresponding to the MPPT circuit. It should be noted that, due to the large number of photovoltaic strings of high-power models, difference calculation can simplify a structure of the device for detecting a direct current arc and can further improve recognition of a subsequent signal waveform for data processing.

The filter amplifier circuit 20 is configured to perform data processing on a result of the MPPT after the background noise signal is removed.

After removing the background noise signal, the signal difference module 10 outputs the result of the MPPT including no background noise signal to the filter amplifier circuit 20. After completing the data processing, the filter amplifier circuit 20 outputs the result subjected to data processing to an ADC sampling port of the processor 30.

The signal difference module 10 may be implemented by a hardware circuit or a software module. An implementation of the signal difference module 10 is not limited herein, but depends on actual applications. Any circuit or module that can implements the functions of the signal difference module 10 is within the protection scope of the present disclosure. In a case that the signal difference module 10 is implemented by a software module, the signal difference module 10 may be a software module inside the processor 30. That is, functions of the signal difference module 10 is implemented by the processor 30. Alternatively, the signal difference module 10 may be an independent processor.

Operation processes of the signal difference module 10 and the filter amplifier circuit 20 can refer to the above embodiment, and are not repeated here.

In a case that at least one of N current transformers corresponding to the same MPPT circuit is arranged opposite to other current transformers of the N current transformers corresponding to the MPPT circuit, the signal difference module 10 is implemented by a signal summation module, so as to remove a background noise signal from current detection results outputted by N current transformers corresponding to the MPPT circuit. However, it should be ensured that two current detection results respectively inputted to the signal summation module are outputted by two current transformers that are arranged opposite. For this case, details are similar to the above description, and are not described in detail herein.

In one embodiment, the device for detecting a direct current arc further includes N self-check circuits. The N multi-input switches are in one-to-one correspondence with the N self-check circuits. Each of the N self-check circuits is configured to detect whether a multi-input switch corresponding to the self-check circuit has a fault.

A string inverter is provided according to an embodiment of the present disclosure. Referring to Figure 9, the string inverter includes an inverter circuit 04, at least one MPPT circuit 02, and at least one device for detecting a direct current arc according to the above embodiment.

For each of the multiple MPPT circuits 02, an input end of the MPPT circuit 02 is connected to a photovoltaic string. Specifically, the input end of the MPPT circuit 02 is connected to output cables of N photovoltaic strings. In the case of M MPPT circuits 02, there are M*N photovoltaic strings connected to the M MPPT circuits 02 in total. It should be noted that PV1+...PVn+ are all photovoltaic strings. It should be noted that PV1+...PVn+ are all represent photovoltaic strings. As shown in Figure 9, one MPPT circuit is connected to output cables of two photovoltaic strings.

The device for detecting a direct current arc is configured to detect a direct current arc of a photovoltaic string connected to a corresponding MPPT circuit 02. Specifically, an output cable of the photovoltaic string connected to the MPPT circuit 02 is provided with a current transformer of the device for detecting a direct current arc, so that device for detecting a direct current arc detects a direct current arc of the photovoltaic string. It should be noted that Figure 9 shows an example in which one device for detecting a direct current arc detects a direct current arc for all the MPPT circuits. In practical applications, the string inverter may include at least two devices 01 for detecting a direct current arc. That is, each of the at least two devices 01 detects a direct current arc for M MPPT circuits detects a direct current arc for all the MPPT circuits. M in the two cases may be the equal or different, depending on specific applications.

It should be noted that photovoltaic strings corresponding to all the MPPT circuits 02 in the string inverter each are provided with a current transformer of the device for detecting a direct current arc. That is, the device for detecting a direct current arc detects all photovoltaic strings connected to the string inverter.

For each of the multiple MPPT circuits 02, an output end of the MPPT circuit 02 is connected to a direct current side of the inverter circuit 04. Specifically, the output end of the MPPT circuit 02 is connected to a direct current bus in the inverter circuit 04.

An alternating current end of the inverter circuit 04 is connected to a power grid.

For a structure and operating principle of the device for detecting a direct current arc, details may refer to the above embodiments, and are not repeated here.

Features described in the various embodiments in this specification may be replaced or combined with each other. The same or similar parts between the various embodiments can be referred to each other. Each embodiment focuses on the differences from other embodiments. Since the system or the system embodiment is basically similar to the method or the method embodiment, the description of the system is relatively simple, and relevant parts can be referred to the description of the method embodiment. The system and system embodiments described above are only illustrative. The units described as separate components may or may not be physically separate. A component shown as a unit may or may not be a physical unit, that is, may be located in one place or may be distributed to multiple network units. Some or all of the modules may be selected as needed to achieve the objects of the solutions of the embodiments. Those skilled in the art can understand and implement the solutions without any creative work.

It should be further understood by those skilled in the art that units and algorithm steps of the examples described in combination with the disclosed embodiments may be implemented by electronic hardware, computer software or a combination thereof. In order to clearly describe interchangeability of the hardware and the software, the units are generally described above based on functions. Whether the functions are realized by the hardware or the software is determined by specific applications of the technical solutions and design constraints. For each of the specific applications, those skilled in the art may adopt a specific implementation to realize the functions described above, and the implementation should fall within the scope of the present disclosure.

## Claims

1. A method for detecting a direct current arc, comprising:
for each of N photovoltaic strings (PV1, PV2,..., PVn) connected to an input end of a maximum power point tracking, MPPT, circuit in a string inverter, acquiring a current detection result of the photovoltaic string;
removing a background noise signal from the N current detection results corresponding to the MPPT circuit; **characterized in that** the method further comprises:
performing data processing and harmonic characteristics analysis on a result corresponding to the MPPT circuit comprising no background noise signal, to obtain a direct current arc detection result for the N photovoltaic strings (PV1, PV2,..., PVn) corresponding to the MPPT circuit.

2. The method for detecting a direct current arc according to claim 1, wherein the for each of N photovoltaic strings (PV1, PV2,..., PVn) connected to an input end of an MPPT circuit in a string inverter, acquiring a current detection result of the photovoltaic string comprises:
inputting the N current detection results corresponding to the MPPT circuit respectively to input terminals of N multi-input switches (40); and
controlling the N multi-input switches (40) to operate to output the N current detection results corresponding to the MPPT circuit at a same time instant.

3. The method for detecting a direct current arc according to claim 1, wherein the removing a background noise signal from the N current detection results corresponding to the MPPT circuit comprises:
calculating a difference between any two of the N current detection results corresponding to the MPPT circuit, as the result corresponding to the MPPT circuit comprising no background noise signal.

4. The method for detecting a direct current arc according to claim 1, wherein the data processing comprises filtering-amplification and analog-to-digital conversion.

5. The method for detecting a direct current arc according to any one of claims 1 to 4, wherein N is equal to 2.

6. A device for detecting a direct current arc, comprising:
a selection module;
a processing module (10, 20, 30); and
M*N current transformers (01, 02, 03...); wherein
M represents the number of maximum power point tracking, MPPT, circuits in a string inverter that correspond to the device for detecting a direct current arc, N represents the number of photovoltaic strings (PV1, PV2,..., PVn) connected to each of the M MPPT circuits, M is a positive integer, and N is an integer greater than 1;
M*N photovoltaic strings (PV1, PV2,..., PVn) are in one-to-one correspondence with the M*N current transformers (01, 02, 03...); and for each of the M*N photovoltaic strings (PV1, PV2,..., PVn), an output cable of the photovoltaic string passes through a magnetic ring of a current transformer corresponding to the photovoltaic string;
input ends of the selection module are connected to output ends of the M*N current transformers (01, 02, 03...) in one-to-one correspondence, and the selection module is configured to acquire, for each of the M MPPT circuits in the string inverter, current detection results of N photovoltaic strings (PV1, PV2,..., PVn) connected to an input end of the MPPT circuit;
**characterised in that**
the processing module (10, 20, 30) is configured to, for each of the M MPPT circuits, remove a background noise signal from N current detection results corresponding to the MPPT circuit, and perform data processing and harmonic characteristics analysis on a result corresponding to the MPPT circuit comprising no background noise signal, to obtain a direct current arc detection result for the N photovoltaic strings (PV1, PV2,..., PVn) corresponding to the MPPT circuit.

7. The device for detecting a direct current arc according to claim 6, wherein the selection module comprises N multi-input switches (40), wherein
for each of the M MPPT circuits:
an output end of the N current transformers corresponding to the MPPT circuit is connected to an input terminal of the N multi-input switches (40), wherein the N current transformers are in one-to-one correspondence with the N multi-input switches (40); and
the N multi-input switches (40) are configured to be controlled to operate to output N current detection results corresponding to the MPPT circuit at a same time instant.

8. The device for detecting a direct current arc according to claim 7, wherein the processing module (10, 20, 30) comprises:
a processor (30); and
a data processing unit (10, 20), wherein
for each of the N multi-input switches (40), an output end of the multi-input switch (40) is connected to the processor (30) via the data processing unit (10, 20); and
for each of the M MPPT circuits:
the data processing unit (10, 20) is configured to remove a background noise signal from N current detection results corresponding to the MPPT circuit; and perform data processing on the result corresponding to the MPPT circuit comprising no background noise signal; and
the processor (30) is configured to: control the N multi-input switches (40) to operate to output N current detection results corresponding to the MPPT circuit at the same time instant; and perform harmonic characteristic analysis on data outputted by the data processing unit (10, 20), to obtain a direct current arc detection result for N photovoltaic strings (PV1, PV2,..., PVn) corresponding to the MPPT circuit.

9. The device for detecting a direct current arc according to claim 8, wherein N current transformers corresponding to a same MPPT circuit are all arranged in a same direction.

10. The device for detecting a direct current arc according to claim 9, wherein the data processing unit (10, 20) comprises a signal difference module (10) and a filter amplifier circuit (20), wherein
for each of the M MPPT circuits:
the signal difference module (10) is configured to calculate a difference between any two of N current detection results corresponding to the MPPT circuit, to remove a background noise signal from the N current detection results outputted by N current transformers corresponding to the MPPT circuit; and
the filter amplifier circuit (20) is configured to perform data processing on the result corresponding to the MPPT circuit comprising no background noise signal.

11. The device for detecting a direct current arc according to claim 10, wherein the signal difference module (10) is implemented by a hardware circuit or a software module.

12. The device for detecting a direct current arc according to claim 8, wherein at least one of N current transformers corresponding to a same MPPT circuit is arranged opposite to other current transformers of the N current transformers corresponding to the MPPT circuit, to remove a background noise signal.

13. The device for detecting a direct current arc according to any one of claims 8 to 12, wherein N is equal to 2.

14. The device for detecting a direct current arc according to any one of claims 8 to 12, further comprising:
N self-check circuits, wherein
the N multi-input switches (40) are in one-to-one correspondence with the N self-check circuits; and
each of the N self-check circuits is configured to detect whether a multi-input switch (40) corresponding to the self-check circuit has a fault.

15. A string inverter, comprising:
an inverter circuit (04);
at least one MPPT circuit; and
at least one of the device for detecting a direct current arc according to any one of claims 8 to 14, wherein
for each of the at least one MPPT circuit:
an input end of the MPPT circuit is connected to a photovoltaic string;
the device for detecting a direct current arc is configured to detect a direct current arc for the photovoltaic string connected to the MPPT circuit; and
an output end of the MPPT circuit is connected to a direct current side of the inverter circuit (04), and
an alternating current end of the inverter circuit (04) is connected to a power grid.

## Patentansprüche

1. Verfahren zur Detektion eines Gleichstromlichtbogens, umfassend:
für jeden von N photovoltaischen Strings (PV1, PV2,..., PVn), die mit einem Eingabeende einer Schaltung zur Suche nach dem maximalen Leistungspunkt, MPPT-Schaltung, in einem Stringwechselrichter verbunden sind, Erhalten eines Stromdetektionsergebnisses des photovoltaischen Strings;
Entfernen eines Hintergrundrauschsignals aus den N Stromdetektionsergebnissen, die der MPPT-Schaltung entsprechen, **dadurch gekennzeichnet, dass** das Verfahren ferner Folgendes umfasst:
Durchführen einer Datenverarbeitung und einer Analyse der Oberwelleneigenschaften an einem Ergebnis, das der MPPT-Schaltung entspricht, die kein Hintergrundrauschsignal umfasst, um ein Ergebnis einer Gleichstromlichtbogendetektion für die N photovoltaischen Strings (PV1, PV2,..., PVn), die der MPPT-Schaltung entsprechen, zu erlangen.

2. Verfahren zur Detektion eines Gleichstromlichtbogens nach Anspruch 1, wobei das Erhalten eines Stromdetektionsergebnisses des photovoltaischen Strings für jeden von N photovoltaischen Strings (PV1, PV2,..., PVn), die mit einem Eingabeende einer MPPT-Schaltung in einem Stringwechselrichter verbunden sind, Folgendes umfasst:
Eingeben der N Stromdetektionsergebnisse, die der MPPT-Schaltung entsprechen, in jeweilige Eingabeanschlüsse von N Mehrfacheingabeschaltern (40); und
Steuern der N Mehrfacheingabeschalter (40), damit diese betrieben werden, um die N Stromdetektionsergebnisse, die der MPPT-Schaltung entsprechen, zu einem selben Zeitpunkt auszugeben.

3. Verfahren zur Detektion eines Gleichstromlichtbogens nach Anspruch 1 wobei das Entfernen eines Hintergrundrauschsignals aus den N Stromdetektionssignalen, die der MPPT-Schaltung entsprechen, Folgendes umfasst:
Berechnen einer Differenz zwischen zwei beliebigen der N Stromdetektionsergebnisse, die der MPPT-Schaltung entsprechen, als das Ergebnis, das der MPPT-Schaltung entspricht, die kein Hintergrundrauschsignal umfasst.

4. Verfahren zur Detektion eines Gleichstromlichtbogens nach Anspruch 1, wobei die Datenverarbeitung Filterung-Verstärkung und Analog-zu-Digital-Umwandlung umfasst.

5. Verfahren zur Detektion eines Gleichstromlichtbogens nach einem der Ansprüche 1 bis 4, wobei N gleich 2 ist.

6. Vorrichtung zur Detektion eines Gleichstromlichtbogens, umfassend:
ein Auswahlmodul;
ein Verarbeitungsmodul (10, 20, 30); und
M*N Stromwandler (01, 02, 03...); wobei
M die Anzahl an Schaltungen zur Suche nach dem maximalen Leistungspunkt, MPPT-Schaltungen, in einem Stringwechselrichter, der der Vorrichtung zur Detektion eines Gleichstromspannungsbogens entspricht, darstellt, N die Anzahl an photovoltaischen Strings (PV1, PV2,..., PVn), die mit jeder der MPPT-Schaltungen verbunden sind, darstellt, M eine positive ganze Zahl ist und N eine ganze Zahl größer als 1 ist;
M*N photovoltaische Strings (PV1, PV2,..., PVn) in einer Eins-zu-Eins-Entsprechung mit den M*N Stromwandlern (01, 02, 03...) stehen; und für jeden der M*N photovoltaischen Strings (PV1, PV2,..., PVn) ein Ausgabekabel des photovoltaischen Strings durch einen magnetischen Ring eines Stromwandlers, der dem photovoltaischen String entspricht, verläuft;
Eingabeenden des Auswahlmoduls in einer Eins-zu-Eins-Entsprechung mit Ausgabeenden der M*N Stromwandler (01, 02, 03...) verbunden sind und das Auswahlmodul dazu konfiguriert ist, für jede der M MPPT-Schaltungen in dem Stringwechselrichter Stromdetektionsergebnisse von N photovoltaischen Strings (PV1, PV2,..., PVn), die mit einem Eingabeende der MPPT-Schaltung verbunden sind, zu erhalten;
**dadurch gekennzeichnet, dass**
das Verarbeitungsmodul (10, 20, 30) dazu konfiguriert ist, für jede der M MPPT-Schaltungen ein Hintergrundrauschsignal aus den N Stromdetektionsergebnissen, die der MPPT-Schaltung entsprechen, zu entfernen und eine Datenverarbeitung und eine Analyse der Oberwelleneigenschaften an einem Ergebnis, das der MPPT-Schaltung entspricht, die kein Hintergrundrauschsignal umfasst, durchzuführen, ein Ergebnis einer Gleichstromlichtbogendetektion für die N photovoltaischen Strings (PV1, PV2,..., PVn), die der MPPT-Schaltung entsprechen, zu erlangen.

7. Vorrichtung zur Detektion eines Gleichstromlichtbogens nach Anspruch 6, wobei das Auswahlmodul N Mehrfacheingabeschalter (40) umfasst, wobei
für jede der M MPPT-Schaltungen:
ein Ausgabeende der N Stromwandler, die der MPPT-Schaltung entsprechen, mit einem Eingabeanschluss der N Mehrfacheingabeschalter (40) verbunden ist, wobei die N Stromwandler in einer Eins-zu-Eins-Entsprechung mit den N Mehrfacheingabeschaltern (40) stehen; und
die N Mehrfacheingabeschalter (40) dazu konfiguriert sind, gesteuert zu werden, damit sie betrieben werden, um die N Stromdetektionsergebnisse, die der MPPT-Schaltung entsprechen, zu einem selben Zeitpunkt auszugeben.

8. Vorrichtung zur Detektion eines Gleichstromlichtbogens nach Anspruch 7, wobei das Verarbeitungsmodul (10, 20, 30) Folgendes umfasst:
einen Prozessor (30); und
eine Datenverarbeitungseinheit (10, 20), wobei
für jede der N Mehrfacheingabeschalter (40) ein Ausgabeende der Mehrfacheingabeschalter (40) über die Datenverarbeitungseinheit (10, 20) mit dem Prozessor (30) verbunden ist; und
für jede der M MPPT-Schaltungen:
die Datenverarbeitungseinheit (10, 20) dazu konfiguriert ist, ein Hintergrundrauschsignal aus den N Stromdetektionsergebnissen, die der MPPT-Schaltung entsprechen, zu entfernen; und eine Datenverarbeitung an dem Ergebnis, das der MPPT-Schaltung entspricht, die kein Hintergrundrauschsignal umfasst, durchzuführen; und
der Prozessor (30) zu Folgendem konfiguriert ist: Steuern der N Mehrfacheingabeschalter (40), damit sie betrieben werden, um N Stromdetektionsergebnisse, die der MPPT-Schaltung entsprechen, zu einem selben Zeitpunkt auszugeben; und Durchführen einer Analyse der Oberwelleneigenschaften an Daten, die durch die Datenverarbeitungseinheit (10, 20) ausgegeben werden, um ein Ergebnis einer Gleichstromlichtbogendetektion für N photovoltaische Strings (PV1, PV2,..., PVn), die der MPPT-Schaltung entsprechen, zu erlangen.

9. Vorrichtung zur Detektion eines Gleichstromlichtbogens nach Anspruch 8, wobei die N Stromwandler, die einer selben MPPT-Schaltung entsprechen, alle in einer selben Richtung angeordnet sind.

10. Vorrichtung zur Detektion eines Gleichstromlichtbogens nach Anspruch 9, wobei die Datenverarbeitungseinheit (10, 20) ein Signaldifferenzmodul (10) und eine Filter-Verstärkerschaltung (20) umfasst, wobei
für jede der M MPPT-Schaltungen:
das Signaldifferenzmodul (10) dazu konfiguriert ist, eine Differenz zwischen zwei beliebigen der N Stromdetektionsergebnisse, die der MPPT-Schaltung entsprechen, zu berechnen, um ein Hintergrundrauschsignal aus den N Stromdetektionsergebnissen, die durch die N Stromwandler ausgegeben werden, die der MPPT-Schaltung entsprechen, zu entfernen; und
die Filter-Verstärker-Schaltung (20) dazu konfiguriert ist, eine Datenverarbeitung an dem Ergebnis, das der MPPT-Schaltung entspricht, die kein Hintergrundrauschsignal umfasst, durchzuführen.

11. Vorrichtung zur Detektion eines Gleichstromlichtbogens nach Anspruch 10, wobei das Signaldifferenzmodul (10) durch eine Hardwareschaltung oder ein Softwaremodul implementiert ist.

12. Vorrichtung zur Detektion eines Gleichstromlichtbogens nach Anspruch 8, wobei mindestens einer der N Stromwandler, die einer selben MPPT-Schaltung entsprechen, gegenüber einem anderen Stromwandler der N Stromwandler, die der MPPT-Schaltung entsprechen, angeordnet ist, um ein Hintergrundrauschsignal zu entfernen.

13. Vorrichtung zur Detektion eines Gleichstromlichtbogens nach einem der Ansprüche 8 bis 12, wobei N gleich 2 ist.

14. Vorrichtung zur Detektion eines Gleichstromlichtbogens nach einem der Ansprüche 8 bis 12, ferner umfassend:
N Selbstüberprüfungsschaltungen, wobei
die N Mehrfacheingabeschalter (40) in einer Eins-zu-Eins-Entsprechung mit den N Selbstüberprüfungsschaltungen stehen; und
jede der N Selbstüberprüfungsschaltungen dazu konfiguriert ist, zu detektieren, ob ein Mehrfacheingabeschalter (40), der der Selbstüberprüfungsschaltung entspricht, einen Fehler aufweist.

15. Stringwechselrichter, umfassend:
eine Wechselrichterschaltung (04);
mindestens eine MPPT-Schaltung; und
mindestens eine der Vorrichtung zur Detektion eines Gleichstromlichtbogens nach einem der Ansprüche 8 bis 14, wobei
für jede der mindestens einen MPPT-Schaltung:
ein Eingabeende der MPPT-Schaltung mit einem photovoltaischen String verbunden ist;
die Vorrichtung zur Detektion eines Gleichstromlichtbogens dazu konfiguriert ist, einen Gleichstromlichtbogen für den photovoltaischen String, der mit der MPPT-Schaltung verbunden ist, zu detektieren; und
ein Ausgabeende der MPPT-Schaltung mit einer Gleichstromseite der Wechselrichterschaltung (04) verbunden ist und
eine Wechselstromseite der Wechselrichterschaltung (04) mit einem Stromnetz verbunden ist.

## Revendications

1. Procédé de détection d'un arc de courant continu, comprenant :
pour chacune des N chaînes photovoltaïques (PV1, PV2,..., PVn) connectées à une extrémité d'entrée d'un circuit de suivi de point de puissance maximale, MPPT, dans un onduleur de chaîne, l'acquisition d'un résultat de détection de courant de la chaîne photovoltaïque ;
la suppression d'un signal de bruit de fond des N résultats de détection de courant correspondant au circuit MPPT ; **caractérisé en ce que** le procédé comprend également :
la réalisation d'un traitement de données et d'une analyse de caractéristiques harmoniques sur un résultat correspondant au circuit MPPT ne comprenant aucun signal de bruit de fond, pour obtenir un résultat de détection d'un arc de courant continu pour les N chaînes photovoltaïques (PV1, PV2,..., PVn) correspondant au circuit MPPT.

2. Procédé de détection d'un arc de courant continu selon la revendication 1, dans lequel pour chacune des N chaînes photovoltaïques (PV1, PV2,..., PVn) connectées à une extrémité d'entrée d'un circuit MPPT dans un onduleur de chaîne, l'acquisition d'un résultat de détection de courant de la chaîne photovoltaïque comprend :
la saisie des N résultats de détection de courant correspondant au circuit MPPT respectivement aux bornes d'entrée de N commutateurs à entrées multiples (40) ; et
la commande des N commutateurs à entrées multiples (40) de manière à ce qu'ils fonctionnent pour délivrer les N résultats de détection de courant correspondant au circuit MPPT à un même moment.

3. Procédé de détection d'un arc de courant continu selon la revendication 1, dans lequel la suppression d'un signal de bruit de fond des N résultats de détection de courant correspondant au circuit MPPT comprend :
le calcul d'une différence entre deux quelconques des N résultats de détection de courant correspondant au circuit MPPT, comme résultat correspondant au circuit MPPT ne comprenant aucun signal de bruit de fond.

4. Procédé de détection d'un arc de courant continu selon la revendication 1, dans lequel le traitement des données comprend un filtrage-amplification et une conversion analogique-numérique.

5. Procédé de détection d'un arc de courant continu selon l'une quelconque des revendications 1 à 4, dans lequel N est égal à 2.

6. Dispositif de détection d'un arc de courant continu, comprenant :
un module de sélection ;
un module de traitement (10, 20, 30) ; et
des transformateurs de courant M*N (01, 02, 03...) ; dans lequel
M représente le nombre de circuits de suivi de point de puissance maximale, MPPT, dans un onduleur de chaîne qui correspondent au dispositif de détection d'un arc de courant continu, N représente le nombre de chaînes photovoltaïques (PV1, PV2,..., PVn) connectées à chacun des M circuits MPPT, M est un nombre entier positif et N est un nombre entier supérieur à 1 ;
des chaînes photovoltaïques M*N (PV1, PV2,..., PVn) sont en correspondance biunivoque avec les transformateurs de courant M*N (01, 02, 03...) ; et pour chacune des chaînes photovoltaïques M*N (PV1, PV2,..., PVn), un câble de sortie de la chaîne photovoltaïque traverse un anneau magnétique d'un transformateur de courant correspondant à la chaîne photovoltaïque ;
des extrémités d'entrée du module de sélection sont connectées aux extrémités de sortie des transformateurs de courant M*N (01, 02, 03...) en correspondance biunivoque, et le module de sélection est configuré pour acquérir, pour chacun des M circuits MPPT dans l'onduleur de chaîne, des résultats de détection de courant de N chaînes photovoltaïques (PV1, PV2,..., PVn) connectées à une extrémité d'entrée du circuit MPPT ;
**caractérisé en ce que**
le module de traitement (10, 20, 30) est configuré pour, pour chacun des M circuits MPPT, supprimer un signal de bruit de fond des N résultats de détection de courant correspondant au circuit MPPT, et effectuer un traitement de données et une analyse de caractéristiques harmoniques sur un résultat correspondant au circuit MPPT ne comprenant aucun signal de bruit de fond, pour obtenir un résultat de détection d'un arc de courant continu pour les N chaînes photovoltaïques (PV1, PV2,..., PVn) correspondant au circuit MPPT.

7. Dispositif de détection d'un arc de courant continu selon la revendication 6, dans lequel le module de sélection comprend N commutateurs à entrées multiples (40), dans lequel
pour chacun des M circuits MPPT :
une extrémité de sortie des N transformateurs de courant correspondant au circuit MPPT est connectée à une borne d'entrée des N commutateurs à entrées multiples (40), dans lequel les N transformateurs de courant sont en correspondance biunivoque avec les N commutateurs à entrées multiples (40) ; et
les N commutateurs à entrées multiples (40) sont configurés pour être commandés de manière à ce qu'ils fonctionnent pour délivrer N résultats de détection de courant correspondant au circuit MPPT à un même moment.

8. Dispositif de détection d'un arc de courant continu selon la revendication 7, dans lequel le module de traitement (10, 20, 30) comprend :
un processeur (30) ; et
une unité de traitement de données (10, 20), dans lequel
pour chacun des N commutateurs à entrées multiples (40), une extrémité de sortie du commutateur à entrées multiples (40) est connectée au processeur (30) par l'intermédiaire de l'unité de traitement de données (10, 20) ; et
pour chacun des M circuits MPPT :
l'unité de traitement de données (10, 20) est configurée pour supprimer un signal de bruit de fond des N résultats de détection de courant correspondant au circuit MPPT ; et effectuer un traitement de données sur le résultat correspondant au circuit MPPT ne comprenant aucun signal de bruit de fond ; et
le processeur (30) est configuré pour : commander les N commutateurs à entrées multiples (40) de manière à ce qu'ils fonctionnent pour délivrer N résultats de détection de courant correspondant au circuit MPPT au même moment ; et effectuer une analyse de caractéristiques harmoniques sur des données émises par l'unité de traitement de données (10, 20), pour obtenir un résultat de détection d'un arc de courant continu pour N chaînes photovoltaïques (PV1, PV2,..., PVn) correspondant au circuit MPPT.

9. Dispositif de détection d'un arc de courant continu selon la revendication 8, dans lequel N transformateurs de courant correspondant à un même circuit MPPT sont tous agencés dans un même sens.

10. Dispositif de détection d'un arc de courant continu selon la revendication 9, dans lequel l'unité de traitement de données (10, 20) comprend un module de différence de signal (10) et un circuit amplificateur de filtre (20), dans lequel
pour chacun des M circuits MPPT :
le module de différence de signal (10) est configuré pour calculer une différence entre deux quelconques de N résultats de détection de courant correspondant au circuit MPPT, pour supprimer un signal de bruit de fond des N résultats de détection de courant émis par N transformateurs de courant correspondant au circuit MPPT ; et
le circuit amplificateur de filtre (20) est configuré pour effectuer un traitement de données sur le résultat correspondant au circuit MPPT ne comprenant aucun signal de bruit de fond.

11. Dispositif de détection d'un arc de courant continu selon la revendication 10, dans lequel le module de différence de signal (10) est mis en œuvre par un circuit matériel ou un module logiciel.

12. Dispositif de détection d'un arc de courant continu selon la revendication 8, dans lequel au moins un des N transformateurs de courant correspondant à un même circuit MPPT est agencé à l'opposé des autres transformateurs de courant des N transformateurs de courant correspondant au circuit MPPT, pour supprimer un signal de bruit de fond.

13. Dispositif de détection d'un arc de courant continu selon l'une quelconque des revendications 8 à 12, dans lequel N est égal à 2.

14. Dispositif de détection d'un arc de courant continu selon l'une quelconque des revendications 8 à 12, comprenant en également :
N circuits d'autovérification, dans lequel
les N commutateurs à entrées multiples (40) sont en correspondance biunivoque avec les N circuits d'autovérification ; et
chacun des N circuits d'autovérification est configuré pour détecter si un commutateur à entrées multiples (40) correspondant au circuit d'autovérification présente un défaut.

15. Onduleur de chaîne, comprenant :
un circuit onduleur (04) ;
au moins un circuit MPPT ; et
au moins un du dispositif de détection d'un arc de courant continu selon l'une quelconque des revendications 8 à 14, dans lequel
pour chacun de l'au moins un circuit MPPT :
une extrémité d'entrée du circuit MPPT est connectée à une chaîne photovoltaïque ;
le dispositif de détection d'un arc de courant continu est configuré pour détecter un arc de courant continu pour la chaîne photovoltaïque connectée au circuit MPPT ; et
une extrémité de sortie du circuit MPPT est connectée à un côté courant continu du circuit onduleur (04), et
une extrémité à courant alternatif du circuit onduleur (04) est connectée à un réseau électrique.
